Europäisches Patentamt

European Patent Office

Office européen des brevets

(19)

(11) Publication number: **0 245 783**

**A2**

(12) # EUROPEAN PATENT APPLICATION

(21) Application number: **87106645.2**

(22) Date of filing: **07.05.87**

(51) Int. Cl.³: **H 01 L 21/76**

(30) Priority: **16.05.86 IT 2046086**

(43) Date of publication of application:
**19.11.87 Bulletin 87/47**

(84) Designated Contracting States:
**DE FR GB NL**

(71) Applicant: **SGS MICROELETTRONICA S.p.A.**
**Stradale Primosole 50**
**I-95121 Catania(IT)**

(72) Inventor: **Cappelletti, Paolo Giuseppe**
**Corso Garibaldi 104**
**I-20030 Seveso (Milano)(IT)**

(74) Representative: **Modiano, Guido et al,**
**MODIANO, JOSIF, PISANTY & STAUB Modiano &**
**Associati Via Meravigli, 16**
**I-20123 Milan(IT)**

(54) Insulation method for integrated circuits, in particular with MOS and CMOS devices.

(57) An insulation method integrated circuits, in particular with MOS and CMOS devices, reducing the minimum distance between the active regions up to the lithographic limit, regardless of the geometry of the field areas, comprises forming, in a semiconductor substrate, trenches having a reduced width, which delimit the active regions of the circuit and the extended field areas, filling the trenches with insulating material and local surface oxidating the field areas.

EP 0 245 783 A2

Croydon Printing Company Ltd.

0245783

INSULATION METHOD FOR INTEGRATED CIRCUITS, IN PARTICULAR WITH MOS AND CMOS DEVICES

The present invention relates to an insulation method for integrated circuits, in particular with MOS and CMOS devices.

As is known, in the current methods for manufacturing MOS and CMOS devices, one of the main limitations to the continuous reduction of the devices below 1 micron lies in the insulation technology. In particular, in the circuits manufactured with very large scale integration (VLSI), the insulation method known as local oxidation (PLANOX/LOCOS - LOCal Oxidation of Silicon) is widespread used. According to this method, a layer of silicon oxide (the so-called pad oxide) is provided below an oxidation mask of silicon nitride ($Ni_3O_4$). This method, though widespread, due to its inherent simplicity and to the good insulating results, does not, however, allow to reduce the minimum distance between the active regions (in which the devices and the transistors, as well as the interconnections, are provided) below the limit of 1.5 microns and therefore cannot be used for circuits with ultra-large-scale integration (ULSI). This limitation is of a physical nature, and is due to the lateral oxidation below the nitride mask which creates a transition region between the thick field oxide and the thin gate oxide, commonly known as PLANOX beak. The formation of this beak unavoidably leads to a dimensional loss and does not allow to reduce the distance between the active regions to the lithographic limits. In order to reduce the length of the beak, it is possible to deposit the nitride directly on the silicon surface without interposing an oxide layer.

However, such a process causes crystalline defects to form in the substrate and a worse electric behavior of the integrated circuit.

In order to solve the above described problem, several innovative insulation technologies have been proposed which allow to increase the density of the circuits to the cost of an unavoidable greater method complexity. Among the various technologies, the most promising ones are those which do not entail conversion of silicon into oxide (thus eliminating the above described problems), the insulation being provided by anisotropic etching of the substrate, so as to obtain trenches and recessed regions therein, and by the subsequent filling of the trenches and of the recesses with polycrystalline silicon, after a slight oxidation (trench insulation) or with deposited oxide (Buried OXide insulation - BOX).

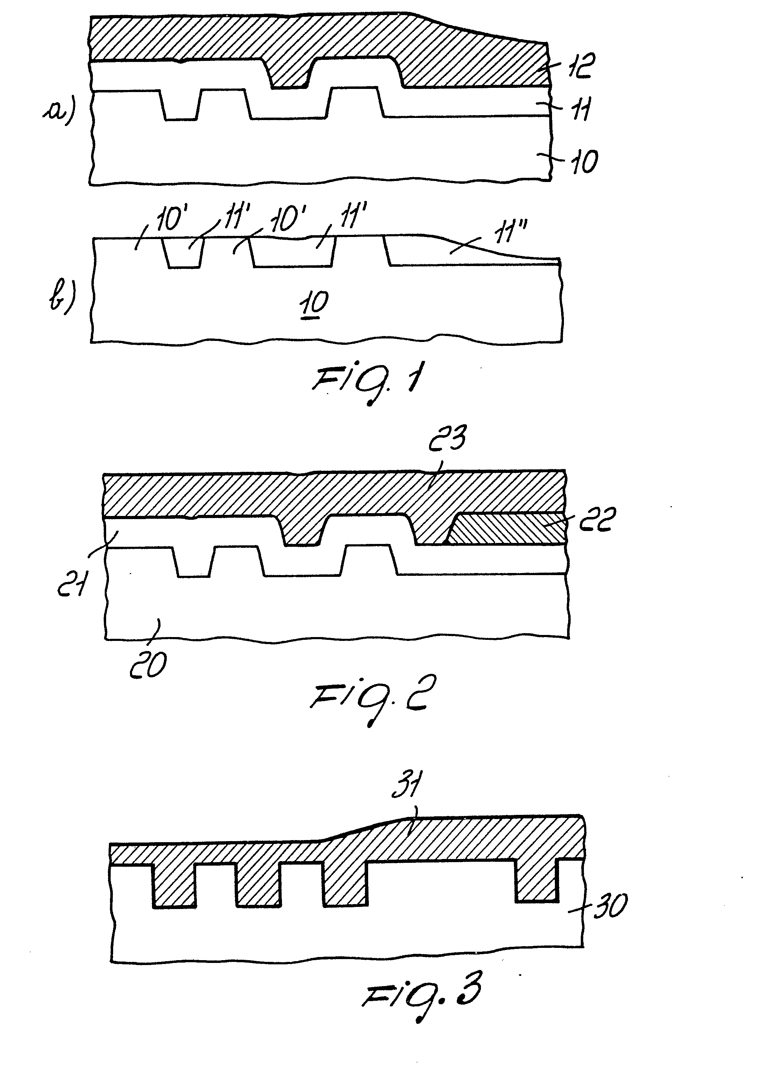

In particular, figures 1 to 3 are cross section views through a silicon wafer to illustrate the BOX insulation method. As can be noted, according to this insulation method, a silicon substrate (indicated in figure 1a at 10) is subjected to anisotropic etching to define the field regions. As a consequence of this phase, the silicon substrate 10 is provided with recesses or trenches at the insulation regions between the active regions and at the extended field areas. Subsequently a vapor-phase oxide is deposited for a thickness at least equal to the depth of the recesses in the silicon. During this step, the layer indicated at 11 in figure 1a is then deposited. Then a planarization step is carried out by depositing a photoresist layer (as indicated at 12 in figure 1a) and by plasma etching with equal speed for the resist and oxide layers until the silicon substrate is uncovered in the active regions. Thus, the structure illustrated in cross section in figure 1b is obtained, where the substrate 10 has uncovered portions 10' which constitute the active regions, between which oxide portions 11'are arranged, which constitute the field areas.

This process with deposited oxide, however, is not free from disadvantages. Indeed, if on one hand it allows reduction of the minimum distance between the active regions, on the other _it does not afford sufficient planarization when field areas with different width are provided. Indeed, on the more extended field areas (as indicated at 11" in figure 1b), during the planarization phase of the wider oxide regions will be more etched away. In order to solve this problem, it is necessary to make use of a double deposition of resist and to use an additional mask to leave the first of the two resist layers only in the wide field areas. This solution is illustrated in figure 2, which illustrates a silicon substrate 20 which has the trench structures at the field areas, the oxide layer 21 covering the face of the substrate 20, the first resist layer 22 left only at the wide field area (to the right in the figure) as well as the second resist layer 23 for planarization of the structure before the final plasma etching.

However, even this more complex solution does not allow to achieve fully satisfactory results, since the thickness of the oxide which is actually left in the recesses depends on the density of the structures due to the variation in the thickness of the resist. Indeed, due to the viscosity of the photo resist liquid, during the distribution on the surface of the silicon wafer to be covered, the free surface of the resist will arrange itself at a level which is substantially related to the average level of the structure which exists below. This phenomenon is illustrated schematically in figure 3, showing a layer 30 (constituted, e.g., by the silicon substrate and by a superimposed oxide layer) in which cavities or grooves are provided, and a resist layer 31 which fills the cavities of the layer 30 and uniformly covers the surface of this layer. As can be seen from this figure, the surface level of the left part of the resist layer, having a higher density of structures, is lower than the right zone, in which there is a smaller density of structures. When a wafer such as the one of figure 3 is subject to the plasma etching to uncover the active regions of the silicon, the lack of uniformity in level of the resist layer will cause a similar lack of uniformity in the level of the oxide in the cavity, thus obtaining an unsatisfactory planarization.

Given this situation, the main aim of the present invention is to provide an insulating method for ULSI integrated circuits, in particular with MOS and CMOS devices, which eliminates the disadvantages featured by the prior art, which in particular allows the minimum distance between the active regions to be reduced to the limit currently obtainable with lithographic processes, forming at the same time a structure showing high planarity.

Within the scope of this aim, a particular object of the present invention is to provide an insulation method which comprises per se known steps which can be easily performed by the machines currently in use in the semiconductor industry, so as to have production costs which are comparable to or even lower than the ones which are currently obtainable, without requiring further masking phases.

Still another object of the present invention is to provide an insulation method which, by eliminating the disadvantages of the current BOX technique, allows to make use of its advantages as to the electric performance of the devices thus obtained.

Not least object of the present invention is to provide an insulation method which can be applied for manufacturing integrated circuits having any field area geometry. The aim described, the objects mentioned and others which will become apparent hereinafter, are achieved by an insulation method for ULSI integrated circuits, in particular with MOS and CMOS devices, according to the invention, characterized in that it comprises:

- forming, in a semiconductor substrate, trenches having a reduced width and delimiting active regions of the circuit to be fabricated and wide field areas;

- filling said trenches with insulating material; and

- local surface oxidation of said field areas.

Further characteristics and advantages will become apparent from the description of a preferred, but not exclusive, embodiment of the invention, illustrated only by way of non-limitative example through the accompanying drawings, wherein:

Figs. 1 to 3 are cross section views across a semiconductor wafer in which insulations have been provided according to the prior art; and

Fig. 4 is a cross section view across a silicon wafer in eight steps of the method according to the invention.

Hereinafter, the description of figures 1 to 3, described previously, is omitted.

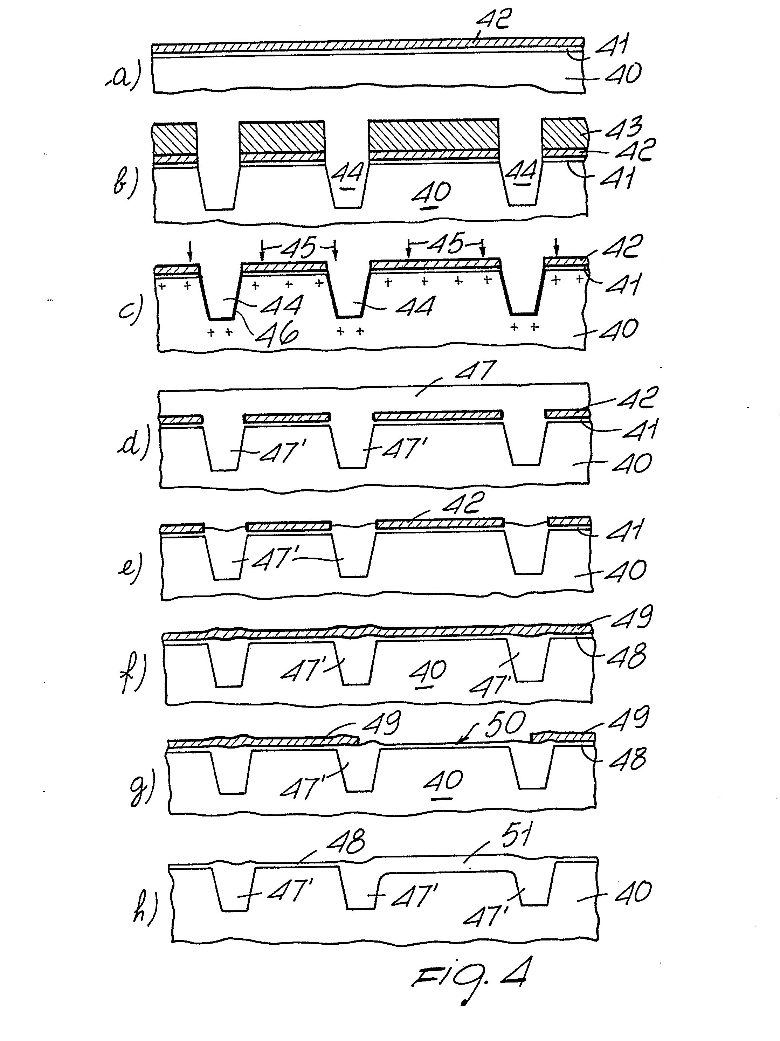

An embodiment of the method according to the invention is now described with reference to figure 4. In particular, on a silicon layer 40 a pad oxide layer 41 is first thermal grown, with a thickness of e.g. 500 $\overset{o}{A}$, as indicated in figure 4a. On this layer, a silicon nitride ($Ni_3O_4$) layer 42 is then deposited, having a thickness of e.g. 2000 $\overset{o}{A}$. On this structure, illustrated in figure 4a, a photoresist layer is then deposited and a masking step is performed to remove the nitride and the oxide in the points where trenches are to be provided; thereafter, an anisotropic silicon etching is performed to provide trenches with a depth ranging between 0.7 and 1 micron, at narrow field areas and at the borders of extended field areas. Thus the structure illustrated in fig. 4b is obtained, showing photoresist portions 43 and trenches 44. The resist is then removed and a thermal oxidation occurs to obtain an oxide layer with a thickness of 500 $\overset{o}{A}$. Then a boron implant is performed to enrich the necessary channel and field areas. This phase is indicated symbolically in figure 4c, in which the arrows 45 represent the boron implant, the thicker trench edges 46 represent the oxidated regions, and the "+" signs represent the implanted boron atoms. Then undoped oxide or silicon oxide doped with boron and phosphorus (Boron Phosphorus Silicon Glass, BPSG) is deposited and reflown, so as to obtain a structure with high planarity. Thus the structure of figure 4d is obtained, showing the deposited oxide layer 47 which, at the trenches, has been indicated at 47'. The planar structure thus obtained is then subject to chemical etching for planarization to remove the excess oxide, leaving only the regions 47' which fill the trenches. At the end, the structure is as shown in figure 4e. Then the surface nitride layer 42 is removed and a further pad oxide layer is grown, as indicated in figure 4f at 48 and having a layer thickness of 500 $\overset{\text{o}}{\text{A}}$. Then a second silicon nitride deposition is carried out, and the layer 49 of figure 4e (having a thickness of e.g. 900 $\overset{\text{o}}{\text{A}}$) is obtained. Then masking resist is deposited, masking is performed to provide windows at the extended field regions (wherein the lateral delimiting borders of the windows are aligned with the trenches, preferably with the center thereof, but must not extend beyond, to avoid the problems of the planox beak according to the prior art), and the second nitride layer is etched away at the mask windows. After removing the masking resist, the structure according to figure 4g is obtained, comprising the silicon substrate 40, the trenches 47', the thin oxide layer 48 and the nitride portions 49 opened at the region indicated at 50 in which a thicker oxide layer is to be provided so as to reduce capacitive couplings between eventual interconnecting lines which will be provided subsequently on the surface of the circuit and the underlying substrate. Then a thermal oxidation treatment is performed, which leads to the formation of the field layer 51 with a thickness of e.g. 4000 $\overset{o}{A}$. Then, after removal of the nitride layer 49, the structure of figure 4h is obtained, showing the silicon substrate 40, the narrow trench regions 47', the thin insulating oxide 48 covering the substrate portions defining the active regions, as well as the thermally grown thick oxide 51.

In practice, as can be seen from the above description of a particular embodiment, the method according to the invention consist of forming the insulation using only trenches with minimal width (typically one micron) so as to obtain a structure already substantially plane after deposition of the oxide. The planarity of the structure in this phase can be further improved by using a doped oxide and by reflowing it after the deposition. In this manner an oxide etching is sufficient to uncover the active regions without the need to use resist and difficult balanced etch steps to planarize the structure. According to the present method, the wide field areas are also insulated by providing trenches which surround them on all sides, while to reduce the capacitive coupling between the device surface and the underlying field area inside the wide field areas a pad oxide is grown, which then requires suitable masking step.

It should be noted that, though in the illustrated example deposited oxide is used as isolating material, for the same purpose it is possible to use deposited polycrystalline silicon.

As can be noted from the previous description, the invention fully achieves the intended aims. Indeed, a method has been provided which is capable of making full use of the advantages offered by the known BOX method, reducing the disadvantages thereof as to planarity lack in the structure thus obtained, in particular if the circuit to be manufactured has a wide variety of geometry and dimensions of the field areas. Indeed, while the field areas having small dimensions are provided in the same manner as in the BOX method, by digging thin trenches which, with the current lithographic methods, can reach at the most 0.7-0.8 microns in theory and 1 micron in practice, to provide the extended field areas these areas are no more completely digged and filled with deposited oxide, which entails the above described disadvantages. Indeed, the wide field area insulation is now obtained by means of thin trenches which therefore do not entail difficulties in planarizing the structure, and the local oxidation has the only aim of reducing the capacitive coupling between the above possible interconnecting lines and the substrate. It should be noted that the proposed solution also solves the problem of the PLANOX beak which is present in current local oxidation technologies, since here the local oxidation in the extended or wide field regions no longer has an insulation function, and the thermally oxidated layer is delimited by the thin trenches.

The method according to the invention therefore allows to make full use of the advantages of the known BOX method, even as to the electric performance of the devices thus obtained. With respect to such technology, the present solution is in any case more satisfactory as to the problem of the variety of the geometries of the field areas, yielding a better final result and requiring operative steps which can be provided simply and in a very controllable manner. In particular, by virtue of the method described for forming the insulation, only two masking steps are necessary, in particular one for forming the trenches and another for local oxidation of the extended field areas, while no further masks are required, e.g., to enrich the boron concentration in the active channel regions and in the field regions.

Moreover, it should be noted that with the method according to the invention the depth of the oxide layer deposited for the planarization no longer assumes particular relevance, since, by virtue of the use of trenches with minimal width, the same are quickly filled by the deposited oxide, thus forming a virtually planar structure. In particular, according to the invention, the thickness of the deposited oxide may range between 0.3 and $0.8 \mu m$.

The invention thus conceived is susceptible to numerous modifications and variations, all of which are within the scope of the inventive concept. Moreover, all the details may be replaced with technically equivalent elements.

## CLAIMS

1. An insulation method for integrated circuits, in particular with MOS and CMOS devices, characterized in that it comprises:
- forming, in a semiconductor substrate, trenches having a reduced width and delimiting active regions of the circuit to be fabricated and wide field areas;
- filling said trenches with insulating material; and
- local surface oxidation of said field areas.

2. A method according to claim 1, characterized in that said insulating material is deposited oxide.

3. A method according to claim 1, characterized in that said insulating material is polycrystalline silicon.

4. A method according to claim 1, characterized in that said trenches have a width ranging between 0.8 and 1.3 microns.

5. A method according to one or more of the preceding claims, characterized in that said trenches have a minimum width obtainable with photolithographic methods.

6. A method according to one or more of the preceding claims, characterized in that for filling said trenches an insulation layer is deposited above said semiconductor substrate, said insulation layer having a thickness comprised between 0.3 and 0.8$\mu$m, and said insulating layer is planarized by removing protruding portions of said insulating layer above said substrate, with said insulating material remaining only within said reduced width trenches.

7. A method according to one or more of the preceding claims, characterized in that it comprises:
- depositing a first uniform thin oxide layer on a semiconductor substrate;

- depositing a first silicon nitride layer;

- photolithographically depositing a first protection mask having windows at regions where trenches are to be formed;

- etching said semiconductor substrate to form the trenches;

- removing said first protective mask;

- thermal oxidating a surface region of said semiconductor substrate at said trenches;

- implanting enrichment boron at said wide field regions and at channel regions;

- depositing a second oxide layer;

- planarizating said second oxide layer;

- removing said first silicon nitride layer;

- depositing a third oxide layer;

- depositing a second silicon nitride layer;

- photolithographically depositing a second protection mask having windows at said wide field regions;

- etching said second nitride layer;

- removing said second protection mask;

- thermal oxidating and removing remaining portions of said second nitride layer.

8. An integrated circuit, in particular MOS and CMOS interated circuit, comprising a semiconductor substrate having active regions and wide field regions, and an insulating layer (47', 48, 51) extending on a face of said substrate, characterized in that said insulation layer has trench formations (47') with reduced width extending towards the interior of said substrate (40) and surrounding said active region and wide field regions and thermally oxidated, wide insulation portions (51) extending on said wide field regions and having extensions substantially equal thereto.

9.  An integrated circuit according to claim 8, characterized in that said trench formations have a width ranging between 0.8 and 1.3 microns.

10.  An integrated circuit, according to claim 8 or 9, characterized in that said wide insulation portions have a depth ranging between 2500 and 4500 $\overset{\circ}{A}$.

0245783

a)

12

11

10

b)

10'  11'  10'  11'

11"

10

Fig. 1

23

22

21

20

Fig. 2

31

30

Fig. 3

0245783

a)

42
41
40

b)

43
42
44   40   44   41

c)

45   45   42
41
44   44
46   40

d)

47
42
41
47'   47'   40

e)

42
41
47'   40

f)

49
48
47'   40   47'

g)

49   50   49
48
47'   40

h)

48   51
47'   47'   47'   40

Fig. 4